# EUROPEAN PATENT SPECIFICATION

(11) **EP 2 514 601 B1**
(45) Date of publication and mention of the grant of the patent: **08.06.2016**
(21) Application number: 12164490.0
(22) Date of filing: 17.04.2012
(51) Int. Cl.: B41F 27/12, B41N 6/00, B65H 23/00

(54) **A cliché mounting machine with an apparatus for providing sealing of flexo-printing photopolymers on sleeves coated by an adhesive strip**
Klicheemontiervorrichtung mit einem Apparat zur Versiegelung flexografischer Fotopolymere auf mit Klebeband beschichteten Hülsen
Machine de montage de cliché avec dispositif pour sceller des photopolymères flexopraphiques sur manchons revêtus d'une bande adhésive

(30) Priority: 22.04.2011 IT MI20110691
(43) Date of publication of application: 24.10.2012
(73) Proprietor: Biessse Equipment Solutions S.r.l., 20018 Sedriano (MI) (IT)
(72) Inventor: Gatti, Roberto, 20018 Sedriano (MI) (IT)
(74) Representative: Saporiti, Emilio Luigi

(56) References cited:
- EP-A1- 0 211 313
- DE-A1- 3 347 733
- GB-A- 1 492 036
- GB-A- 2 017 570
- US-A- 4 871 650

## Description

### BACKGROUND OF THE INVENTION

The present invention relates to a cliché mounting machine with an apparatus, for providing a perfect sealing, without any air bubbles, of photopolymers, and adapted to exploit a maximum adhesive power of the used adhesive strip.

Printing machines using a photopolymer plate applied on the roller sleeve by a biadhesive material for transferring ink to desired supports or media are already known.

The photopolymer and flexo-printing mounting processes, however, are affected by two main problems: the penetration of air bubbles between the photopolymer and biadhesive strip, and a raising or detaching of the photopolymer before and/or during the printing.

Both the above phenomena negatively affect a good printing result, and cause damages requiring the printing machine to be stopped for repairing operations.

In particular, in the assembling operations for mounting the mentioned photopolymers on the cliché mounting machine, in a normal condition, air bubbles penetrate between the photopolymer itself and biadhesive strip, which causes, in the printing process, the above mentioned problems.

In particular, the photopolymer raising problem may occur both in the time period from the photopolymer assembling and printing process starting, and during the printing operation itself, as the photopolymer edges tend to be raised and accordingly to damage the printed material.

The document US 4 871 650 discloses a process for coating a printing cylinder or a sleeve with continuous, seamless, photosensitive layer which comprises: winding a prefabricated solid thermoplastically processable, essentially solvent-free unsupported photosensitive layer at least twice around the printing cylinder or sleeve without bubbles and with the displacement of the air between the individual strata to form two or more strata laying one on the top of the other; heating the total applied photosensitive layer material under pressure to bond the individual strata of the layer; and shaping the continuous end bonded photosensitive layer to form an exactly cylindrical surface, and smoothing the surface of the layer.

### SUMMARY OF THE INVENTION

Accordingly, the aim of the present invention is to provide such a cliché mounting machine allowing to obtain a perfectly even laminating of the photopolymers to the adhesive strip, thereby facilitating the removal of the air bubbles from the laminated assembly while providing a maximum pressure to provide in turn a maximum adhesion of the used adhesive strip. In fact, since the adhesive strip is sensible to pressure, by increasing with given limits the pressure applied at the assembling stage, it is possible to achieve a maximum adhesive power from the adhesive strip.

The above aim is achieved by the cliche mounting machine according to claim 1.

### BRIEF DESCRIPTION OF THE DRAWINGS

Further characteristics and advantages of the present invention will become more apparent hereinafter from the following disclosure of a preferred, though not exclusive, embodiment of the invention which is illustrated, by way of an indicative but not limitative example, in the accompanying drawings, where:
Figure 1 is a side elevation view of the present invention, being shown with the sleeve supporting system at a starting position thereof, that is in a lowered position before applying the photopolymer to the sleeve;

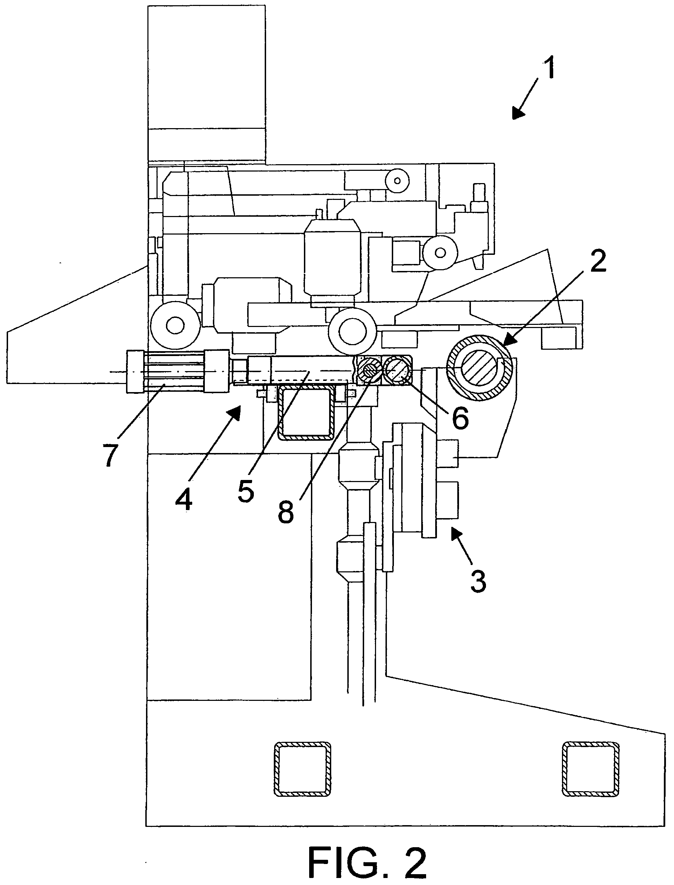

Figure 2 is a detail view showing the present invention in its rest position facing the sleeve;
Figure 3 is a view similar to Figure 2 and showing the apparatus in operation, that is as it applies a pressure on the sleeve with the photopolymers applied thereto;
Figure 4 is a further elevation and partially cross-sectioned view, on an enlarged scale, showing the subject system as it applies a pressure on the photopolymer-sleeve assembly;
Figure 5 is a top plan view of the system before starting the pressure application;
Figure 6 is a further top plan view, similar to Figure 5, but showing the system in its pressing operating stage;

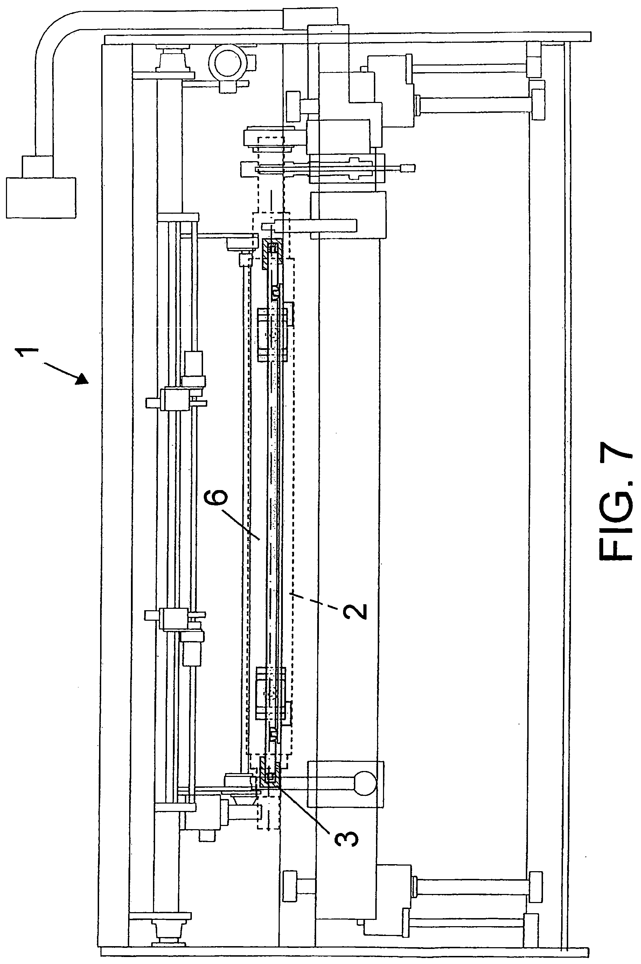

Figure 7 is a front elevation view of the invention; and

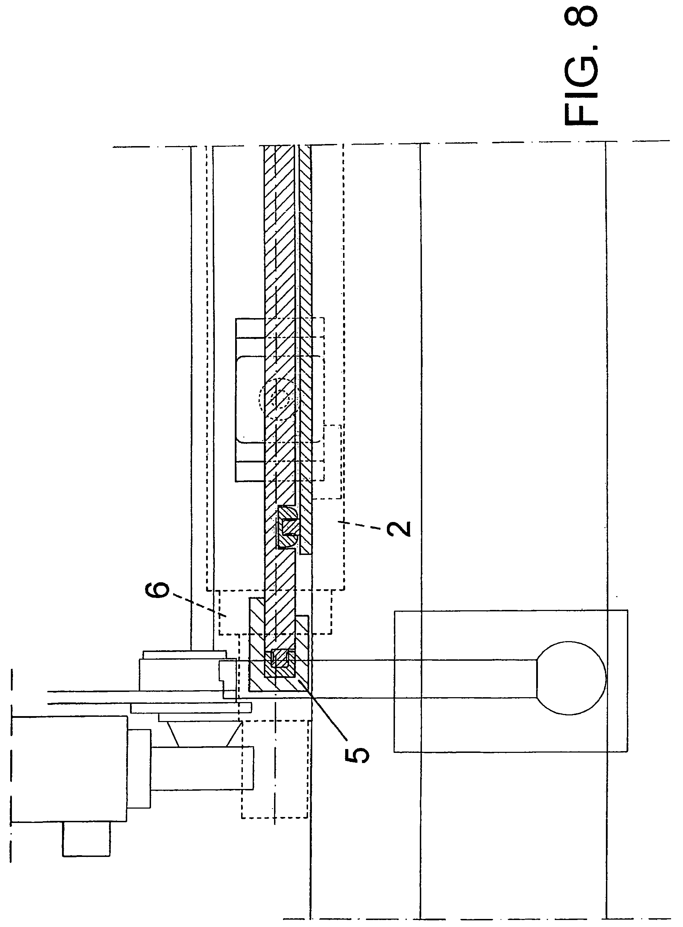

Figure 8 is a further front elevation view of the invention showing a detail of the pressure or pressing system included in the present invention.

### DESCRIPTION OF THE PREFERRED EMBODIMENTS

With reference to the number references of the above mentioned figures, the cliché mounting machine, according to the present invention, which has been generally indicated by the reference number 1, comprises a sleeve 2, thereon the photopolymers are mounted by biadhesive strips.

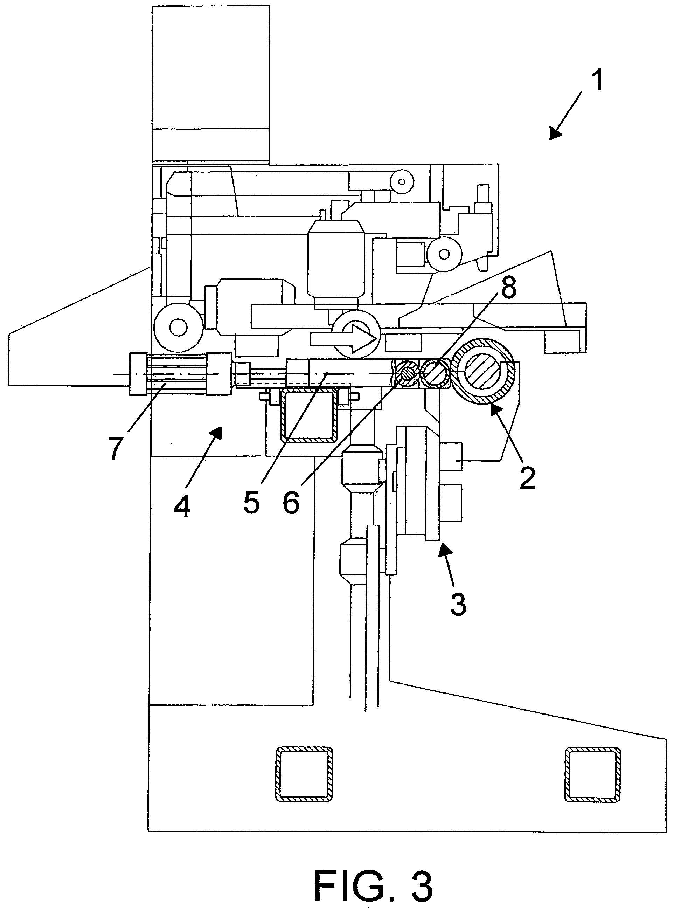

The sleeve 2 with the photopolymers assembled thereon is in turn mounted on a raising or elevator device 3, allowing to arrange said sleeve at a position perfectly aligned with the apparatus according to the present invention, as shown in Figure 3.

In said raised position thereof, the sleeve is facing the pressing device 4 which comprises a carriage 5.

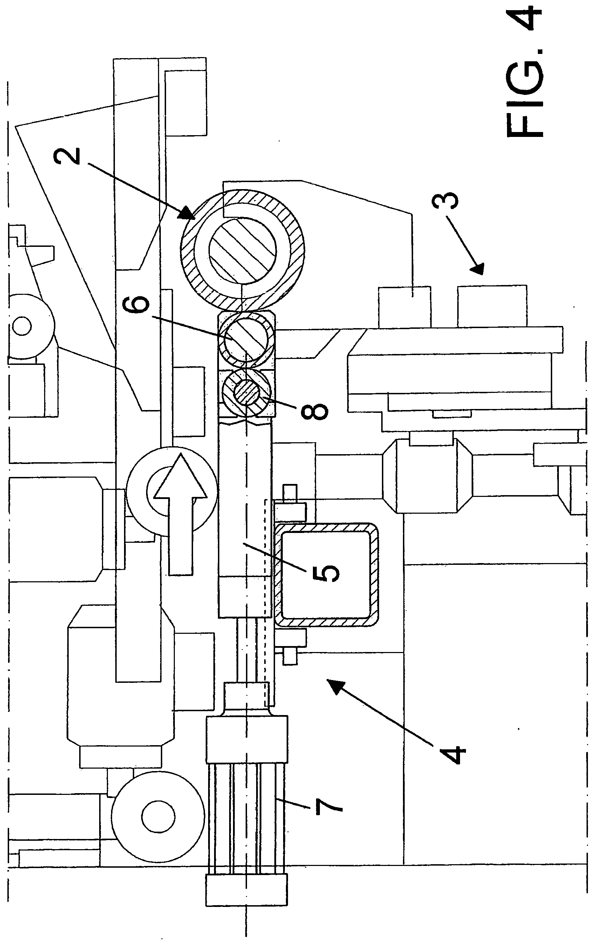

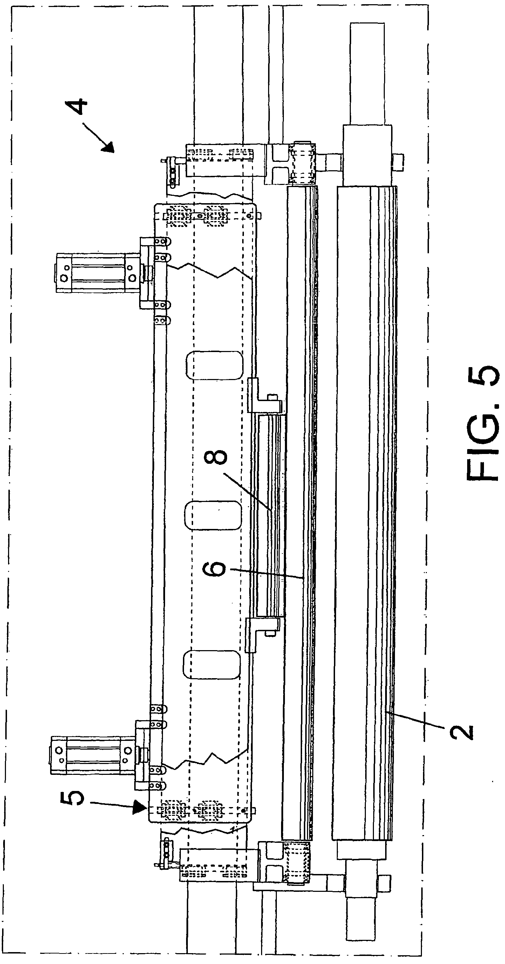

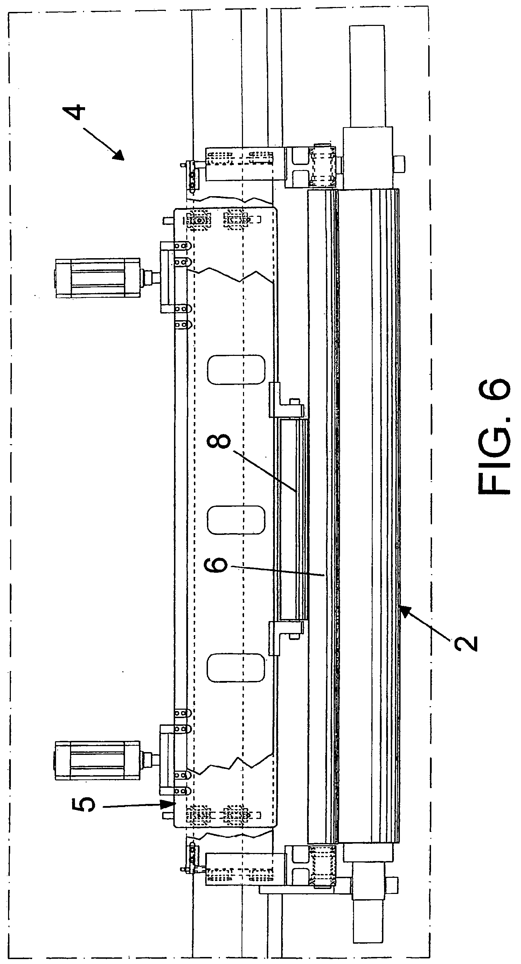

The carriage 5 supports a pressing roller 6 and may be driven from a withdrawn position, shown in Figure 5, thereat the pressing roller 6 is spaced from the sleeve 2, to an active position, shown in Figures 4 and 6, thereat said pressing roller 6 is pressed against the sleeve 2.

The carriage 5 is driven by a pair of pneumatic actuators 7, designed for providing the operating pressure required by the roller 6 on the sleeve 2.

The pressing device 4 comprises, moreover, an auxiliary counter-roller 8 mounted on said carriage 5 thereby abutting on the pressing roller 6 at a position which is diametrically opposite to the sleeve 2.

Said auxiliary roller 8 has a smaller length than the pressing roller 6 and is arranged at a central position thereby preventing the pressing roller 6 from being deflected as it applies pressure on the sleeve 2.

The inventive apparatus comprises moreover an improved mechanical feedback system for dynamically compensating for flexures, during the pressing stage.

More specifically, the pressing roller 6 is advantageously made of a special anti-adhesive long duration rubber material providing a maximum abrading resistance even as it contacts the adhesive parts and graphic ridges of the photopolymers.

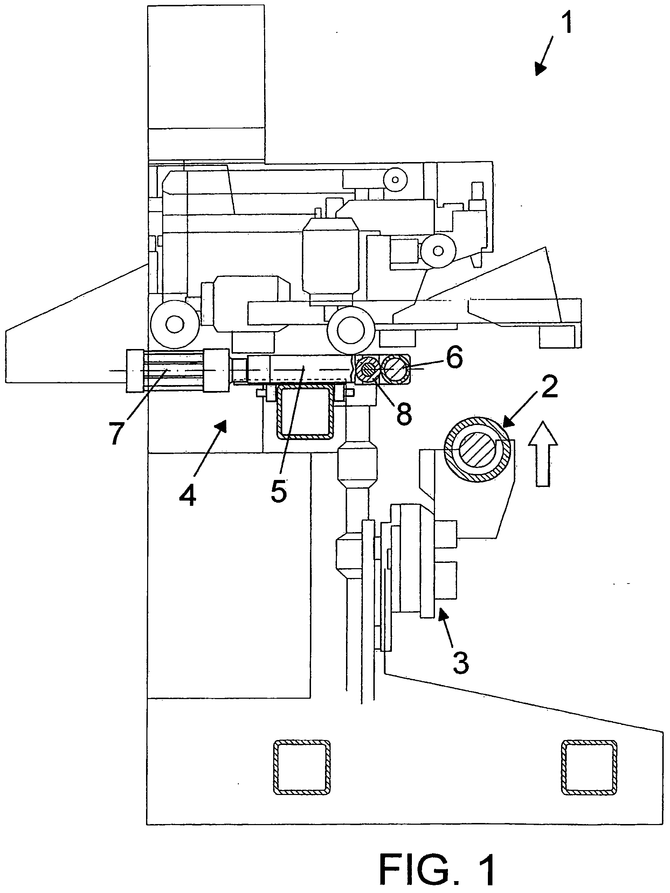

The apparatus according to the present invention operates as follows:
with the raising device 3 at a lowered position thereof, as shown in Figure 1, the sleeve covered by the adhesive strip is mounted and the raising device is operated so as to bring said sleeve 2 to a raised position, as shown in Figure 3.

After having applied the photopolymers on the sleeve, the pressing device 4 is so driven as to drive in turn the carriage 5 to bring the pressing roller 6 against the sleeve 2 which is rotatively driven under pressure.

The device according to the present invention has been designed to provide a pressure up to 9 Bar, that is 900 kPa, to the photopolymers without deflecting the pressing roller.

A main feature of the present invention is that the delivered pressure is applied in a "modular" or graduated manner. In fact, the level of the pressure being delivered may be fully controlled by quantity, time and intermediate ramp controlling parameters.

The pressure cycle is applied through a total of four steps preventing air bubbles from being entrapped, thereby delivering the maximum pressure so as not to stress the adhesive strip, photopolymers and sleeve.

This represents the gist of the invention.

The inventive system or apparatus further comprises a software fully controlling the apparatus and also managing all the required data in addition to allowing a full control of the pressure cycle and apparatus diagnostics.

The apparatus, moreover, automatically recalculates the proper pressure to be applied based on the number of photopolymers and the adhesive strip being used.

It has been found that the invention fully achieves the intended aim and objects.

In fact, the inventive apparatus provides several technical and functional advantages, among which a very important one is overcoming the problem of embedding air bubbles and detaching the adhesive strip from the photopolymer.

Thus, the inventive apparatus provides a high quality and accurate printing, in addition to an improved operating efficiency owing to the elimination of any operating down times.

In practicing the invention, the used materials, as well as the contingent size and shapes can be any, depending on requirements.

## Claims

1. A cliché or plate mounting machine for assembling photopolymers on a sleeve, said machine comprising:
- a sleeve (2) on which said photopolymers are applied by biadhesive strips:
- an apparatus for providing a perfect sealing, without air bubbles, of photopolymers assembled on the sleeve;
- a raising device (3) on which the sleeve (2) is mounted for arranging said sleeve at a position perfectly aligned with the apparatus by facing a pressing device (4) of the apparatus;
- said pressing device (4) comprising a carriage (5) supporting a pressing roller (6) and an auxiliary counter-roller (8) for preventing the pressing roller (6) from being bent;
- said carriage (5) is drivable through a valve and actuator system adapted to provide different pressure steps which may be fully parameterized;
- and said carriage (5) being movable between a withdrawn position, in which said pressing roller (6) is spaced from said sleeve (2) and an active position, in which said pressing roller (6) is pressed against said sleeve (2).

2. A machine, according to claim 1, **characterized in that** said auxiliary counter-roller (8) is mounted on said carriage (5) so as to abut against said pressing roller (6) at a position diametrically opposite to said sleeve (2).

3. A machine, according to claims 1 and 2, **characterized in that** said auxiliary counter-roller (8) has a length less than that of said pressing roller (6) and is arranged at a central position thereby preventing said pressing roller (6) from bending as a pressure is applied on said sleeve (2).

4. A machine, according to claim 1, **characterized in that** said carriage is driven by a pair of pneumatic actuators providing the operating pressure required by said pressing roller (6) on said sleeve (2).

5. A machine, according to claim 1, **characterized in that** said pressing device (4) provides a modular pressure the level of which is adapted to be parameterized by quantity, time and intermediate ramp controlling parameters.

6. A machine, according to any preceding claims, **characterized in that** said pressing device (4) operates based on a pressure cycle comprising a total of four steps preventing air bubbles from being entrapped thereby delivering the maximum pressure so as not to stress the adhesive strips, photopolymers and sleeve.

7. A machine, according to any preceding claims, **characterized in that** said pressing roller (6) is made of an anti-adhesive long duration rubber material providing a maximum abrading resistance even as it contacts adhesive parts and graphic ridges of the photopolymers.

8. A machine, according to any preceding claims, **characterized in that** said apparatus further comprises a mechanical feedback system for dynamically compensating flexures, as said pressing device applies its pressure.

9. A machine, according to any preceding claims, **characterized in that** said apparatus comprises a managing software controlling all the apparatus operating functions and also managing all the required data in addition to allowing a full control of pressure cycle and apparatus diagnostics.

10. A machine, according to any preceding claims, **characterized in that** said software is designed to automatically recalculate a proper pressure to be applied by on a number of photopolymers and biadhesive strips.

11. A machine, according to one or more of the preceding claims, **characterized in that** said pressing device (4) provides a gradual pressure varying from 0 to 9 bars without bending the pressing roller (6).

## Patentansprüche

1. Klischee- oder Plattenmontagemaschine für das Auftragen von Fotopolymeren auf ein Sleeve, wobei die Maschine Folgendes umfasst:
- ein Sleeve (2), auf das die Polymere durch beidseitig haftende Streifen aufgebracht sind,
- einen Apparat zum Bereitstellen einer perfekten luftblasenlosen Dichtung für die auf das Sleeve aufgetragenen Fotopolymere,
- eine Hebevorrichtung (3), auf die das Sleeve (2) montiert ist, um das Sleeve an einer Position anzuordnen, die perfekt zum Apparat ausgerichtet ist, indem sie einer Andruckvorrichtung (4) des Apparats gegenüberliegt,
- wobei die Andruckvorrichtung (4) einen Schlitten (5) umfasst, der eine Andruckwalze (6) und eine Hilfsgegenwalze (8) trägt, um ein Biegen der Andruckwalze (6) zu verhindern,
- wobei der Schlitten (5) durch ein Ventil- und Betätigungselementesystem zu betreiben ist, das dafür eingerichtet ist, Schritte mit unterschiedlichen Drücken bereitzustellen, die vollständig parametrisiert sein können,
- und wobei der Schlitten (5) zwischen einer zurückgezogenen Position, in der die Andruckwalze (6) vom Sleeve (2) beabstandet ist, und einer aktiven Position, in der die Andruckwalze (6) an das Sleeve (2) angedrückt ist, beweglich ist.

2. Maschine nach Anspruch 1, **dadurch gekennzeichnet, dass** die Hilfsgegenwalze (8) derart an den Schlitten (5) montiert ist, dass sie an einer Position diametral gegenüber dem Sleeve (2) an der Andruckwalze (6) anliegt.

3. Maschine nach Anspruch 1 und 2, **dadurch gekennzeichnet, dass** die Hilfsgegenwalze (8) eine Länge aufweist, die geringer als die der Andruckwalze (6) ist, und an einer Mittelposition angeordnet ist, wodurch verhindert wird, dass sich die Andruckwalze (6) biegt, wenn auf das Sleeve (2) ein Druck angelegt wird.

4. Maschine nach Anspruch 1, **dadurch gekennzeichnet, dass** der Schlitten durch ein Paar pneumatischer Betätigungselemente angetrieben wird, die den Betriebsdruck bereitstellen, der von der Andruckwalze (6) auf dem Sleeve (2) benötigt wird.

5. Maschine nach Anspruch 1, **dadurch gekennzeichnet, dass** die Andruckvorrichtung (4) einen modularen Druck bereitstellt, dessen Höhe dafür eingerichtet ist, mittels Druck-, Zeit- und Zwischenrampen-Steuerungsparametern parametrisiert zu sein.

6. Maschine nach einem der vorhergehenden Ansprüche, **dadurch gekennzeichnet, dass** die Andruckvorrichtung (4) auf der Grundlage eines Druckzyklus arbeitet, der insgesamt vier Schritten umfasst, die verhindern, dass Luftblasen eingeschlossen werden, wodurch der maximale Druck zugeführt wird, so dass die Haftstreifen, Fotopolymere und das Sleeve nicht belastet werden.

7. Maschine nach einem der vorhergehenden Ansprüche, **dadurch gekennzeichnet, dass** die Andruckwalze (6) aus einem antiadhäsiven Kautschukmaterial mit langer Haltbarkeitsdauer besteht, das eine maximale Abriebfestigkeit bereitstellt, auch wenn es mit haftenden Teilen und grafischen Erhebungen der Fotopolymere in Kontakt kommt.

8. Maschine nach einem der vorhergehenden Ansprüche, **dadurch gekennzeichnet, dass** der Apparat ferner ein mechanisches Rückmeldesystem zum dynamischen Kompensieren von Biegungen umfasst, wenn die Andruckvorrichtung ihren Druck ausübt.

9. Maschine nach einem der vorhergehenden Ansprüche, **dadurch gekennzeichnet, dass** der Apparat eine Betriebsführungssoftware umfasst, die zusätzlich zum Ermöglichen einer vollständigen Steuerung des Druckzyklus und von Apparatediagnostik alle Betriebsfunktionen des Apparates steuert und außerdem alle erforderlichen Daten verwaltet.

10. Maschine nach einem der vorhergehenden Ansprüche, **dadurch gekennzeichnet, dass** die Software dafür gestaltet ist, den richtigen Druck automatisch neu zu berechnen, der auf eine Anzahl von Fotopolymeren und beidseitig haftenden Streifen auszuüben ist.

11. Maschine nach einem oder mehreren der vorhergehenden Ansprüche, **dadurch gekennzeichnet, dass** die Andruckvorrichtung (4) einen abgestuften Druck bereitstellt, der von 0 bis 9 bar variiert, ohne die Andruckwalze (6) zu biegen.

## Revendications

1. Machine de montage de cliché ou de plaque pour assembler des photopolymères sur un manchon, ladite machine comprenant :
- un manchon (2) sur lequel lesdits photopolymères sont appliqués grâce à des bandes biadhésives ;
- un appareil pour fournir un scellage parfait, sans bulles d'air, des photopolymères assemblés sur le manchon ;
- un dispositif de levage (3) sur lequel le manchon (2) est monté pour disposer ledit manchon dans une position parfaitement alignée avec l'appareil en faisant face à un dispositif de pressage (4) de l'appareil ;
- ledit dispositif de pressage (4) comprenant un chariot (5) supportant un rouleau presseur (6) et un contre-rouleau auxiliaire (8) pour empêcher le fléchissement du rouleau presseur (6) ;
- ledit chariot (5) pouvant être entraîné par un système à soupape et vérin adapté pour fournir différentes étapes de pression qui peuvent être entièrement paramétrées ;
- et ledit chariot (5) pouvant se déplacer entre une position de retrait dans laquelle ledit rouleau presseur (6) est espacé par rapport audit manchon (2) et une position active dans laquelle ledit rouleau presseur (6) est pressé contre ledit manchon (2).

2. Machine selon la revendication 1,
**caractérisée en ce que** ledit contre-rouleau auxiliaire (8) est monté sur ledit chariot (5) de manière à buter contre ledit rouleau presseur (6) dans une position diamétralement opposée audit manchon (2).

3. Machine selon les revendications 1 et 2,
**caractérisée en ce que** ledit contre-rouleau auxiliaire (8) a une longueur inférieure à celle dudit rouleau presseur (6) et est disposé dans une position centrale en empêchant de la sorte que ledit rouleau presseur (6) fléchisse lorsqu'une pression est appliquée sur ledit manchon (2).

4. Machine selon la revendication 1,
**caractérisée en ce que** ledit chariot est entraîné par une paire d'actionneurs pneumatiques fournissant la pression de fonctionnement requise par ledit rouleau presseur (6) sur ledit manchon (2).

5. Machine selon la revendication 1,
**caractérisée en ce que** ledit dispositif de pressage (4) fournit une pression modulaire dont le niveau est adapté pour être paramétré par une quantité, le temps et des paramètres de contrôle intermédiaires de déclivité.

6. Machine selon l'une quelconque des revendications précédentes,
**caractérisée en ce que** ledit dispositif de pressage (4) fonctionne sur la base d'un cycle de pression comprenant un total de quatre étapes empêchant des bulles d'air d'être piégées en délivrant de la sorte la pression maximale de manière à ne pas stresser les bandes adhésives, les photopolymères et le manchon.

7. Machine selon l'une quelconque des revendications précédentes,
**caractérisée en ce que** ledit rouleau presseur (6) est formé par un matériau en caoutchouc longue durée antiadhésif fournissant une résistance à l'abrasion même lorsqu'il entre en contact avec des parties adhésives et des raies graphiques des photopolymères.

8. Machine selon l'une quelconque des revendications précédentes,
**caractérisée en ce que** ledit appareil comprend en outre un système de rétroaction mécanique pour compenser dynamiquement des flexions lorsque ledit dispositif de pressage applique sa pression.

9. Machine selon l'une quelconque des revendications précédentes,
**caractérisée en ce que** ledit appareil comprend un logiciel de gestion contrôlant toutes les fonctions opérationnelles de l'appareil et gérant également toutes les données requises en plus de permettre un contrôle complet du cycle de pression et des diagnostics d'appareil.

10. Machine selon l'une quelconque des revendications précédentes,
**caractérisée en ce que** ledit logiciel est conçu pour recalculer automatiquement une pression correcte à appliquer grâce à un nombre de photopolymères et de bandes biadhésives.

11. Machine selon l'une ou plusieurs des revendications précédentes,
**caractérisée en ce que** ledit dispositif de pressage (4) fournit une pression progressive variant de 0 à 9 bars sans faire fléchir le rouleau presseur (6).
